# FASCICULE DE BREVET EUROPEEN

(11) **EP 0 617 841 B1**
(45) Date de publication et mention de la délivrance du brevet: **26.08.1998**
(21) Numéro de dépôt: 93902302.4
(22) Date de dépôt: 04.12.1992
(51) Int. Cl.: H01L 21/78

(54) **Procédé de réalisation de composants semi-conducteurs avec récupération du substrat par voie électrochimique**
Verfahren zur Herstellung von Halbleiterkomponenten, bei dem das Substrat auf elektrochemischem Wege wiedergewonnen wird
Method of making semiconductor components with recovery of the substrate by electrochemical means

(30) Priorité: 06.12.1991 FR 9115138
(43) Date de publication de la demande: 05.10.1994
(73) Titulaire: PICOGIGA S.A., 91940 Les Ulis (FR)
(72) Inventeur: NUYEN, Linh, T., F-75016 Paris (FR)
(74) Mandataire: Dupuis-Latour, Dominique
(86) Numéro de dépôt international: FR9201154
(87) Numéro de publication internationale: WO9311562

(56) Documents cités:
- EP-A- 0 029 334
- EP-A- 0 417 851
- FR-A- 2 639 149
- JOURNAL OF CRYSTAL GROWTH. vol. 45, 1978, AMSTERDAM NL pages 277 - 280 M. KONAGAI ET AL 'High efficiency GaAs thin film solar cells by peeled film technology' cité dans la demande
- APPLIED PHYSICS LETTERS. vol. 51, no. 26, 28 Décembre 1987, NEW YORK US pages 2222 - 2224 E. YABLONOVITCH ET AL 'Extreme selectivity in the lift-off of epitaxial GaAs films' cité dans la demande

## Description

L'invention concerne un procédé de réalisation de composants électroniques à semiconducteurs.

L'invention, comme on le verra, s'applique à une grande variété de composants, incluant aussi bien ceux réalisés sur substrats en matériaux du groupe IV (silicium essentiellement) que ceux réalisés à base de matériaux III-V (GaAs, InP, etc) ou II-VI.

Ce procédé prévoit de détacher et récupérer le substrat sur lequel sont réalisés les composants.

Il a été déjà proposé de réaliser des composants électroniques et de les séparer ensuite de leur substrat. Cette technique a déjà été proposée notamment pour des diodes Schottky ou des MESFETs sur substrat GaAs ou InP, la séparation étant obtenue par dissolution chimique d'une couche de AlₓGa₁₋ₓAs à forte teneur en aluminium (fraction molaire x_{Al} ≥ 0,50) épitaxiée au préalable entre le substrat et les couches actives de matériau semiconducteur constituant les composants électroniques proprement dits. On pourra se référer à cet égard à M. Konagai et al., *High Efficiency GaAs Thin Film Solar Cells by Peeled Film Technology,* Journal of Crystal Growth, n° 45 (1978), p. 277, E. Yablonovitch et al., *Extreme Selectivity in the Lift-Off of Epitaxial GaAs Films,* Appl. Phys. Lett., Vol. 51, n° 26, 28 décembre 1987, p. 222, ou encore H. Schumacher et al., *High-Speed InP/GaInAs Photodiode on Sapphire Substrate,* Electronics Letters, Vol. 25, n° 24, 23 novembre 1989, p. 1653. Le EP-A-0 029 334 décrit une technique mettant en oeuvre une dissolution complète du substrat.

Cette technique est cependant limitée aux cas particuliers des composants sur substrat GaAs ou InP et, du fait du caractère spécifique de la couche intercalaire soluble, n'est pas transposable tel quel à des composants autres que les diodes Schottky ou MESFETs sur substrats GaAs ou InP.

L'un des buts de la présente invention est de proposer un procédé de réalisation de composants semiconducteurs applicable à une très grande variété de composants (transistor à effet de champ, transistor bipolaire, redresseur commandé, etc.) et à un très grand nombre de matériaux (composants sur silicium, sur GaAs, sur matériaux II-VI, etc.).

Le fait de pouvoir séparer les composants du substrat sur lequel ils ont été réalisés présente un nombre important d'avantages.

En premier lieu, cette technique permet de réduire l'épaisseur du composant par suppression complète du substrat, avec tous les avantages corrélatifs qui en découlent : le substrat étant éliminé, il n'est plus nécessaire de réaliser des vias pour le traverser et assurer la prise de contact à la couche inférieure du composant ; le coût de fabrication de ce dernier en est donc diminué d'autant ; le poids du composant est considérablement réduit, ce qui est avantageux dans le domaine spatial ; pour certaines applications optoélectroniques, le substrat peut constituer une gêne car il n'est pas transparent aux longueurs d'onde concernées ; et enfin la dissipation thermique est considérablement améliorée du fait de la suppression de la résistance thermique constituée, dans les composants actuels, par la présence du substrat (notamment pour GaAs et InP, qui sont mauvais conducteurs de la chaleur).

En second lieu, et surtout, le procédé de l'invention permet la récupération du matériau du substrat, sans destruction de celui-ci, économisant ainsi, outre le coût de l'étape de rodage, le coût du substrat, qui pourra être réutilisé tel quel. Cet avantage est d'autant plus net que le substrat est réalisé en un matériau coûteux.

On verra par ailleurs que le procédé de l'invention peut être mis en oeuvre de manière précise, facilement contrôlable et aisément industrialisable, permettant ainsi une production de masse à faible coût.

À cet effet, le procédé de l'invention est énoncé en revendication 1. Les sous-revendications visent des modes de mise en oeuvre avantageux.

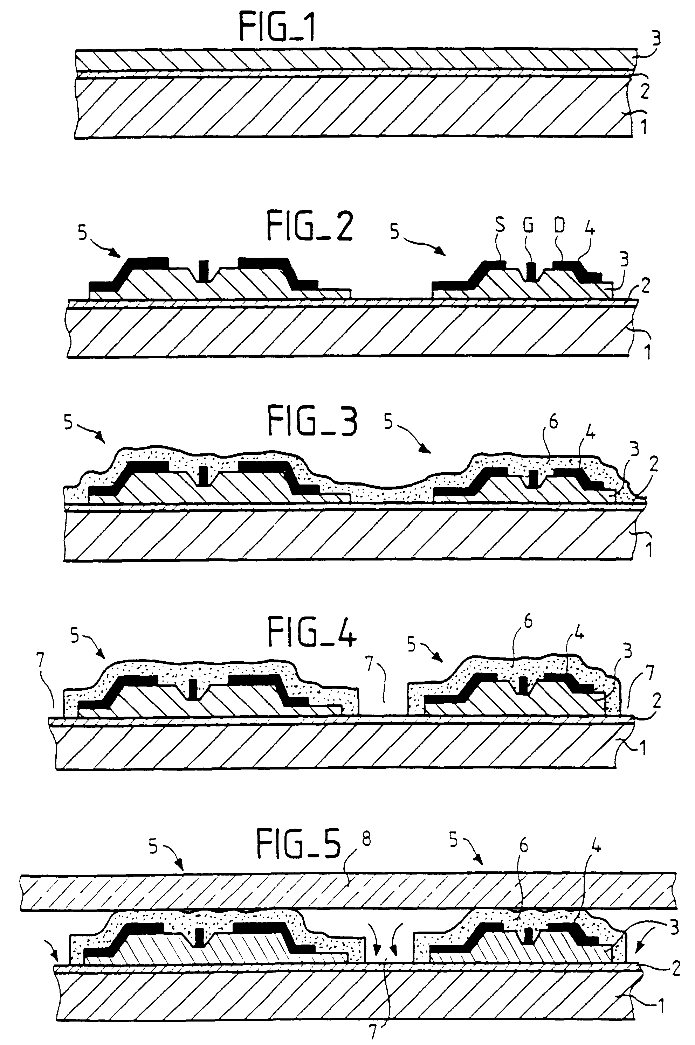

On va maintenant décrire un exemple de mise en oeuvre de l'invention en référence aux dessins annexés, sur lesquels les figures 1 à 9 illustrent, de façon schématique, les différentes étapes de réalisation d'un composant selon le procédé de l'invention.

Le composant décrit sur ces figures est bien entendu donné uniquement à titre d'exemple, et pourrait aussi bien être d'un autre type ou d'une autre configuration.

Sur la figure 1, on a représenté en couches la tranche de départ, comprenant un substrat 1, épais (typiquement d'une épaisseur de l'ordre de 500 micromètres) en silicium, GaAs, InP, etc., sur lequel on épitaxie sur une très faible épaisseur (par exemple de l'ordre de quelques centaines de nanomètres) une couche intercalaire 2 dopée p⁺. Sur cette couche intercalaire 2, on forme ensuite une couche active 3 dont le dopage, l'épaisseur et la constitution seront choisis en fonction du composant à réaliser.

La couche intercalaire 2 peut également être obtenue par implantation à travers la couche 3.

La couche active 3 peut être constituée d'un empilement de couches successives présentant chacune une composition, un dopage et une épaisseur différents, le terme « couche active » désignant ici collectivement cet empilement.

La couche active comporte au moins une couche inférieure de type n, c'est-à-dire qu'elle peut être simplement constituée d'une telle couche n (par exemple dans le cas d'un transistor à effet de champ, les trois électrodes de source, de grille et de drain étant alors déposées directement sur cette couche n unique, ou bien d'une pluralité de couches n et p, dans le cas de structures plus complexes (une telle couche active multiple peut être par exemple une structure n-p-n pour un transistor bipolaire). On verra plus loin que, si la couche active comporte une ou plusieurs couches p, des précautions particulières doivent être prises.

À l'étape de la figure 2, on a exécuté diverses étapes de procédé connues de gravure chimique, ionique ou ionique réactive de la couche active 3, de dépôt d'une métallisation 4, etc. de manière à constituer les divers composants individuels 5 avec leurs électrodes de source S, de grille G et de drain D (dans le cas d'un transistor à effet de champ), d'émetteur, de base et de collecteur (dans le cas d'un transistor bipolaire), d'anode, de cathode et de gâchette (dans le cas d'un redresseur commandé), etc.

On notera que l'on peut réaliser aussi bien des composants isolés (transistors individuels) que des groupes de composants, qui peuvent correspondre à une fonction logique ou analogique donnée, les divers composants élémentaires de ces groupes de composants étant alors réalisés sur une même région de la couche active 3 et reliés entre eux par des métallisation appropriées.

Les étapes des figures 3 et 4 que l'on va maintenant détailler, concernent uniquement le cas, exposé plus haut, où la couche active comporte une ou plusieurs couches dopées p. Si la couche active ne comporte que des matériaux dopés n, on peut passer directement à l'étape de la figure 5.

Ainsi, à l'étape de la figure 3, on a revêtu l'ensemble des composants d'une couche de protection 6 d'un matériau inerte, qui peut être en particulier une résine photosensible ou une couche de passivation du composant (couche d'oxyde ou de nitrure), déposée par une voie classique.

À l'étape de la figure 4, on a gravé la couche de protection 6 de manière à mettre à nu, dans des régions repérées 7, la couche intercalaire 2 dopée p⁺, tout en protégeant les flancs des composants ou groupes de composants (notamment les couches dopées p de la couche active), qui sont alors en forme d'îlots isolés les uns des autres sur le substrat. Ces ouvertures 7 sont réalisées par les techniques classiques de photolithographie ou de lithographie électronique, dans le cas d'une couche en résine photosensible, ou de gravure, dans le cas d'une couche de passivation.

À l'étape de la figure 5, on vient recouvrir l'ensemble des composants par une plaque commune 8, par exemple collée sur la couche protectrice 6 après dépôt de cette dernière.

L'étape de traitement suivante consiste, une fois la plaque 8 collée, à dissoudre la couche intercalaire 2 dopée p⁺ par voie électrochimique (dissolution anodique), le matériau semiconducteur de cette couche, mis en contact avec un électrolyte (par exemple KOH), constituant l'anode par rapport à une électrode de référence. Par le phénomène d'« anode soluble » cette électrode va progressivement disparaître, c'est-à-dire que le matériau de la couche intercalaire ― et de cette seule couche ― va se trouver progressivement éliminé. L'électrolyte pénètre par les interstices formés entre les composants et vient attaquer cette couche aux endroits 7 mis à nu, puis par le chant de cette couche, comme illustré par les flèches de la figure 5. Le reste de la structure, notamment le substrat, les régions protégées par la couche inerte 6, la plaque support 8 et la colle qui la retient aux composants, qui sont neutres du point de vue électrochimique, sont en revanche laissés intacts (comme on l'a noté plus haut, le matériau constituant la face inférieure de la couche active 3, c'est-à-dire la face en contact avec la couche intercalaire 2, n'est pas dopé p, autrement le composant serait attaqué par le dessous lors de la dissolution électrochimique de la couche intercalaire 2 ; ce matériau est généralement une couche dopée n⁺).

Pour de plus amples détails sur le phénomène de dissolution électrochimique d'un matériau semiconducteur, on pourra se référer notamment à l'étude de T. Ambridge et al., *The Electrochemical Characterization of n-Type Gallium Arsenide,* Journal of Applied Electrochemistry, Vol. 3 (1973), p. 1, qui décrit un procédé dans lequel cette dissolution est utilisée pour déterminer le dopage d'une couche de GaAs de type n. Il ne s'agit toutefois que d'un procédé visant à la caractérisation électrique d'une couche de surface d'une structure semiconductrice, et il n'est nulle part envisagé d'utiliser cette technique pour séparer un substrat des composants réalisés sur celui-ci par dissolution d'une couche intercalaire enterrée.

On notera que, dans ce phénomène de dissolution anodique, ce sont les trous qui participent au transfert de charges, pas les électrons (voir notamment à ce sujet H. Gerisher, *Physical Chemistry* ― *An Advanced Treatise : IX A Electrochemistry,* Chap. 5, édité par Eyring, Henderson & Jost, Academic Press, New York (1970)). Autrement dit, en l'absence de trous, le semiconducteur n'est pas dissous, ce qui revient également à dire que seuls les semiconducteurs de type p peuvent être dissous. En ce qui concerne les semiconducteurs de type n, ils ne peuvent être dissous que si l'on génère des trous par une action exogène, typiquement par illumination. C'est pourquoi, dans l'étape de processus de dissolution anodique selon l'invention, on prévoit d'effectuer cette dissolution anodique dans l'obscurité, afin de dissoudre exclusivement le semiconducteur de type p et de laisser intacts les semiconducteurs de type n, notamment le matériau constituant la région inférieure de la couche active.

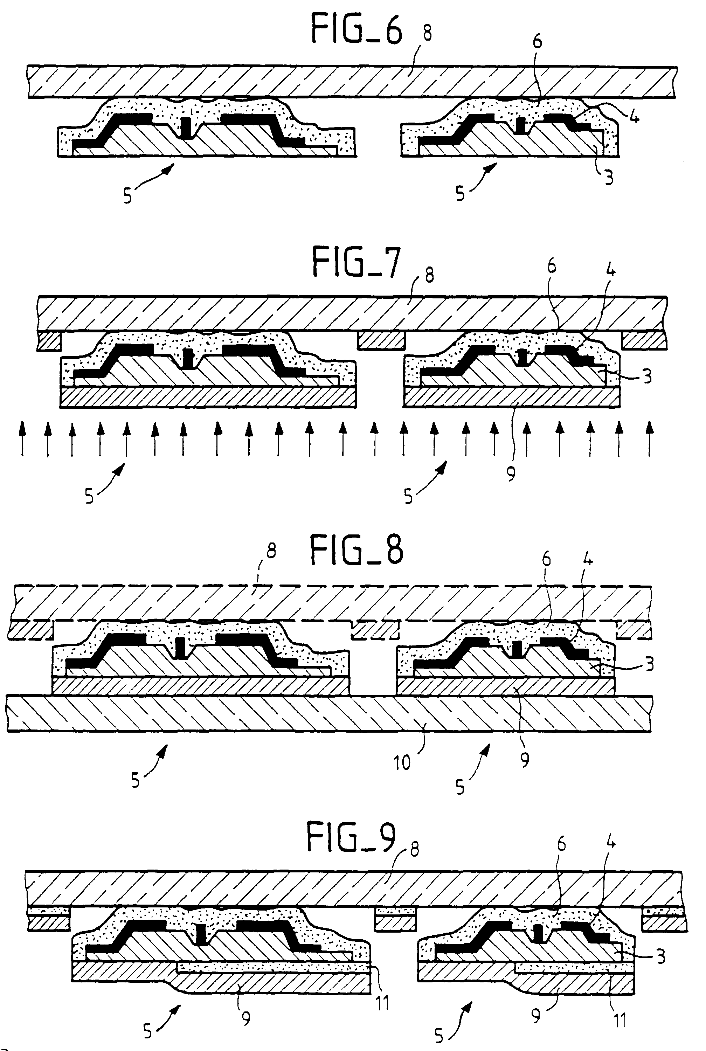

Une fois cette dissolution opérée, on aboutit à la situation de la figure 6.

À la figure 7, le processus se poursuit par dépôt d'une métallisation 9 de la face libre, c'est-à-dire de la face postérieure de la couche dopée 3. La métallisation 9 peut être déposée par toute méthode classique (évaporation, etc.), ce qui permet une prise de contact direct sur la face arrière de la couche dopée sans interposition du substrat, et donc sans avoir besoin de former des vias ; en outre, du fait de ce contact direct, cette métallisation joue efficacement un rôle de drain thermique.

Les opérations peuvent se poursuivre de diverses manières.

On peut tout d'abord dissoudre la colle afin de séparer de la plaque support 8 les composants individuels 5 ou groupes de composants et récupérer les différentes puces.

Il est également possible, avant de dissoudre la colle, de fixer l'ensemble sur une « peau de tambour » selon une méthode connue, permettant ainsi de retenir et de séparer plus aisément les diverses puces après dissolution de la colle.

Par ailleurs, pour certaines applications telles que les cellules solaires ou les diodes électroluminescentes, on peut préférer laisser la plaque collée afin d'avoir un réseau de composants interconnectés électriquement (soit sur cette plaque elle-même, soit d'une autre manière). On peut ainsi réaliser directement des panneaux électroluminescents de grande dimension, la plaque 8 étant alors une plaque transparente en une matière appropriée, minérale ou organique.

Il est également possible, une fois le réseau réalisé, de coller les composants, par leur face inférieure, sur une autre plaque support 10, comme illustré figure 8, afin d'obtenir une structure « sandwich » électroluminescente ou photosensible, formée d'un réseau de diodes retenues entre deux plaques 8 et 10 de protection et de maintien.

On peut également, après collage sur la plaque postérieure 10, décoller la plaque frontale 8, celle-ci ne jouant alors le rôle que de support provisoire avant report des composants sur la plaque support définitive 10. Cette plaque 10 peut être notamment un substrat métallique, pour réduire la résistance électrique d'accès des composants, un substrat à forte conductivité thermique, pour favoriser la dissipation thermique, un substrat isolant, pour réduire les capacités parasites du circuit intégré, un substrat réfléchissant, pour augmenter l'efficacité optique du composant, etc.

Par ailleurs, la plaque support peut elle-même être un composant actif.

En outre, comme illustré figure 9, on peut prévoir de déposer avant métallisation une couche isolante 11 en regard de l'électrode de drain du transistor afin de réduire les capacités parasites qui pourraient résulter de la trop grande proximité de cette électrode et de la métallisation de la face arrière (puisque le substrat est maintenant absent).

## Revendications

1. Un procédé de réalisation de composants semiconducteurs, caractérisé par les étapes consistant à :
(a) produire un substrat (1) semi-isolant ou de type n,
(b) former en surface de ce substrat une couche intercalaire (2) d'un matériau dopé p⁺,
(c) former sur cette couche intercalaire une couche active (3) comportant au moins une couche inférieure dopée n,
(d) réaliser, par gravure et métallisation de cette couche active, un ensemble de composants semiconducteurs (5), des régions (7) de la couche intercalaire étant mises à nu par ladite gravure entre ces composants ou des groupes de ces composants,
(g) fixer sur l'ensemble ainsi réalisé une plaque support commune (8) recouvrant et solidarisant mécaniquement les composants, et
(h) dissoudre par voie anodique et sans illumination le matériau de la couche intercalaire en laissant intacts les autres matériaux, la couche intercalaire étant attaquée à l'endroit desdites régions mises à nu, et séparer ainsi, sans le dissoudre, le substrat d'avec lesdits composants, une face arrière de la couche active (3) des composants ou groupes de composants étant ainsi découverte.

2. Le procédé de la revendication 1, dans lequel, la couche active comprenant également au moins une couche dopée p, il est prévu en outre, entre les étapes (d) et (g), des étapes consistant à :
(e) appliquer sur l'ensemble de composants et sur les régions mises à nu une couche protectrice (6) d'un matériau de passivation ou d'une résine photosensible, et
(f) graver sélectivement cette couche protectrice jusqu'à mettre à nu la couche intercalaire à l'endroit desdites régions entre ces composants ou les groupes de ces composants.

3. Le procédé de l'une des revendlcations 1 et 2, comprenant en outre une étape consistant à :
(i) déposer une metallisation (9) sur ladite face arrière de la couche active des composants ou groupes de composants découverte par la séparation du substrat à l'étape (h).

4. Le procédé de l'une des revendications 1 à 3, comprenant en outre une étape consistant à :
(k) séparer les différents composants individuels ou groupes de composants d'avec ladite plaque support commune.

5. Le procédé de l'une des revendications 1 à 4, comprenant en outre une étape consistant à :
(j) fixer sur un organe support commun (10), en face arrière, les différents composants individuels ou groupes de composants.

6. Le procédé de la revendication 5, dans lequel ledit organe support commun porte des lignes d'interconnexion des composants.

7. Le procédé de l'une des revendications 5 ou 6, dans lequel ledit organe support commun est optiquement transparent et les composants sont des composants optoélectroniques.

8. Le procédé de l'une des revendications 1 à 7, dans lequel ladite plaque support commune porte des lignes d'interconnexion des composants.

9. Le procédé de l'une des revendications 1 à 8, dans lequel ladite plaque support commune est optiquement transparente et les composants sont des composants optoélectroniques.

## Patentansprüche

1. Verfahren zur Herstellung von Halbleiterkomponenten, gekennzeichnet durch die folgenden Schritte:
(a) Herstellen eines Substrates (1), das halbisolierend oder vom n-Typ, ist,
(b) Bilden einer Zwischenschicht (2) aus einem p⁺-dotierten Material auf der Oberfläche des Substrates,
(c) Bilden einer aktiven Schicht (3), die zumindest eine untere n-dotierte Schicht aufweist, auf dieser Zwischenschicht,
(d) Realisieren einer Gesamtheit von Halbleiterkomponenten (5) durch Gravur oder Metallisierung dieser aktiven Schicht, wobei Bereiche (7) der Zwischenschicht durch die Gravur zwischen diesen Komponenten oder Gruppen dieser Komponenten freigelegt werden,
(g) Befestigen einer gemeinsamen Trägerplatte (8) auf der so realisierten Gesamtheit, die mechanisch die Komponenten überdeckt und befestigt, und
(h) Auflösen auf anodischem Wege und ohne Beleuchtung des Materials der Zwischenschicht, wobei die anderen Materialien intakt gelassen werden und wobei die Zwischenschicht an dem Ort der freigelegten Bereichen angegriffen wird, und so, ohne aufzulösen, Trennen des Substrates von den Komponenten, wobei eine hintere Seite der aktiven Schicht (3) der Komponenten oder Gruppen von Komponenten dadurch freigelegt ist.

2. Verfahren gemäß Anspruch 1, bei dem die aktive Schicht gleichfalls zumindest eine p-dotierte Schicht aufweist, und wobei außerdem zwischen den Schritten (d) und (g) Schritte vorgesehen sind, die darin bestehen:
(e) auf der Gesamtheit der Komponenten und auf den freigelegten Bereichen eine Schutzschicht (6) aus einem Passivierungsmaterial oder einem fotoempfindlichen Harz aufzubringen, und
(f) selektiv diese Schutzschicht zu gravieren, bis die Zwischenschicht am Ort der Bereiche zwischen den Komponenten oder Komponentengruppen freigelegt ist.

3. Verfahren gemäß einem der Ansprüche 1 und 2, das außerdem einen Schritt aufweist, der darin besteht:
(i) eine Metallisierung (9) auf der hinteren Seite der aktiven Schicht der Komponenten oder Komponentengruppen zu deponieren, die durch die Trennung des Substrates in Schritt (h) freigelegt worden ist.

4. Verfahren gemäß einem der Ansprüche 1 bis 3, das außerdem einen Schritt aufweist, der darin besteht:
(k) die unterschiedlichen Einzelkomponenten oder Komponentengruppen von der gemeinsamen Trägerplatte zu trennen.

5. Verfahren gemäß einem der Ansprüche 1 bis 4, das außerdem einen Schritt aufweist, der darin besteht,:
(j) auf einer gemeinsamen Trägereinrichtung (10) auf der hinteren Seite die unterschiedlichen Einzelkomponenten oder Komponentengruppen zu befestigen.

6. Verfahren gemäß Anspruch 5, bei dem die gemeinsame Trägereinrichtung Verbindungsleitungen für die Komponenten trägt.

7. Verfahren gemäß einem der Ansprüche 5 oder 6, bei dem die gemeinsame Trägereinrichtung optisch transparent ist und wobei die Komponenten optoelektronische Komponenten sind.

8. Verfahren gemäß einem der Ansprüche 1 bis 7, bei dem die gemeinsame Trägerplatte Verbindungsleitungen für die Komponenten trägt.

9. Verfahren gemäß einem der Ansprüche 1 bis 8, bei dem die gemeinsame Trägerplatte optisch transparent ist und wobei die Komponente optoelektronische Komponenten sind.

## Claims

1. A method of making semiconductor components, the method being characterized by the following steps:
a) producing a semi-insulating or n-type substrate (1);
b) forming a separating layer (2) of a p⁺-type doped material on the surface of said substrate;
c) forming an active layer (3) on said separating layer, the active layer including at least a bottom layer with n-type doping;
d) making a set of semiconductor components (5) by etching and metallizing said active layer, regions (7) of the separating layer being bared by said etching between said components or groups of said components;
g) fixing a common support plate (8) on the assembly made in this way, thereby covering and holding the components together mechanically; and
h) dissolving the material of the separating layer anodically and without illumination while leaving the other materials intact, said separating layer being attacked in the area of said bared regions, and accordingly separating the substrate from said components without dissolving the substrate, a rear face of said active layer (3) of the components or groups of components being thus uncovered.

2. The method of claim 1 in which, said active layer also including at least one p-type doped layer, further steps are provided between steps d) and g) consisting in:
e) covering the set of components and the bared regions with a protective layer (6) of a passivation material or of a photosensitive resin; and
f) selectively etching said protective layer so as to bare the separating layer in the area of said regions between the components or groups of said components.

3. The method of claim 1 or 2, further including a step consisting in:
i) depositing a metallization (9) on said rear face of the active layer of the components or groups of components uncovered by the separation of the substrate at step h).

4. The method of any one of claims 1 to 3, further including the step consisting in:
k) separating the various individual components or groups of components from said common support plate.

5. The method of any one of claims 1 to 4, further including a step consisting in:
j) fixing the various individual components or groups of components via their rear faces onto a common support member (10).

6. The method of claim 5, in which said common support member carry component interconnection lines.

7. The method of any one of claims 5 or 6, in which said common support member is optically transparent, and the components are optoelectronic components.

8. The method of any one of claims 1 to 7, in which said common support plate carry component interconnection lines.

9. The method of any one of claims 1 to 8, in which said common support plate is optically transparent, and the components are optoelectronic components.
